Europäisches Patentamt

European Patent Office

Office européen des brevets

(11) Publication number: **0 180 479 B1**

# EUROPEAN PATENT SPECIFICATION

(45) Date of publication of patent specification: **10.06.92**   (51) Int. Cl.⁵: **H01L 33/00, H01L 27/15**

(21) Application number: **85307912.7**

(22) Date of filing: **31.10.85**

(54) **Light-emitting diode array.**

(30) Priority: **02.11.84 US 667706**
**02.05.85 US 729707**

(43) Date of publication of application:
**07.05.86 Bulletin 86/19**

(45) Publication of the grant of the patent:
**10.06.92 Bulletin 92/24**

(84) Designated Contracting States:
**DE FR GB**

(56) References cited:
**FR-A- 2 080 849**      **FR-A- 2 197 297**
**GB-A- 1 467 096**      **GB-A- 2 085 227**
**GB-A- 2 099 221**      **GB-A- 2 104 266**

**FUJITSU SCIENTIFIC & TECHNICAL JOUR-NAL, vol. 19, no. 3, September 1983, pages 315-322, Kawasaki, JP; T. SUGAHARA et al.: "High radiance AlGaAs DH LED array by MBE"**

(73) Proprietor: **XEROX CORPORATION**
**Xerox Square - 020**
**Rochester New York 14644(US)**

(72) Inventor: **Daniele, Joseph John**
**321 Thornell Road**
**Pittsford New York 14534(US)**
Inventor: **Araghi, Mehdi Najm**
**906 DeWitt Road**
**Webster New York 14580(US)**

(74) Representative: **Weatherald, Keith Baynes et al**
**Rank Xerox Patent Department Albion House, 55 New Oxford Street**
**London WC1A 1BS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The invention relates to light-emitting diode (LED) arrays, and more particularly, to a method of fabricating an LED array which may be combined with other like LED arrays to form a full-width image write bar.

The use of an array of LEDs to write images on a record member, such as the photoreceptor of a xerographic type imaging system, has taken on renewed interest with the current interest in electronic image printers and the increased LED efficiencies obtained with gallium arsenide (GaAs) as LED substrate. As will be understood, LED arrays typically comprise one or more linear rows of LEDs in close juxtaposition with one another on a single chip or substrate. In electronic printer applications, the individual LEDs of the array are actuated in accordance with an image signal input. The resulting image rays created by the LEDs, which are focused onto the photoreceptor, create or write a latent electrostatic image on the photoreceptor as the photoreceptor is moved in synchronism therewith. Following this, the latent electrostatic image is developed, transferred to a suitable copy substrate material such as a copy sheet, and thereafter fused or fixed to provide a permanent copy.

However, the number of LEDs that can be packed onto a single chip or wafer is limited, and this, in turn, limits the image resolution that can be achieved with a single LED array. Joining several of the smaller LED arrays together to form a longer array, and particularly, to form a full-length array with increased resolution, along with the attendant simplification of the printer optical system that this allows, is desirable.

A primary limitation on resolution and density of a full-page width LED array is the need to wire each individual LED to an off-chip driver circuit. Much higher resolution and lower cost can be achieved if the drive circuitry can be on the same chip as the LED. This would eliminate much of the hybrid wiring normally required. Moreover, if these self-driving chips could be accurately cut and butted to form a continuous single line LED array, this would eliminate expensive optical or electronic stitching methods.

Infra-red (IR) LEDs can be made with an efficiency more than an order of magnitude, and in some cases two orders of magnitude, greater than present day visible light LEDs. Moreover, because of recent advances in materials preparation, such as metallo-organic chemical vapor deposition (MOCVD) and molecular beam epitaxy (MBE), IR LEDs can now be made from commercially-available materials like gallium arsenide (GaAs) or gallium aluminum arsenide (GaAlAs) in heterostructures which show reliability and uniformity much superior to previous visible-light LEDs. However, because these high efficiency IR LED arrays are structured differently from previous LED arrays, IR LED arrays have their own constraints and advantages.

Because of past photoreceptor spectral limitations and the consequent unavailability of IR photorceptors, LED arrays are currently made from zinc-diffused gallium arsenide phosphide (Ga(As,P)) grown epitaxially on gallium arsenide (GaAs) or gallium phosphide (GaP). As will be understood, Ga(As,P) is an indirect gap semiconductor and LEDs constructed of this material are of relatively low external efficiency, usually 0.02 to 0.05%. With nitrogen doping, efficiency may be raised to 0.2 to 0.5% but there are uniformity problems associated with this.

These types of LED arrays are also Lambertian radiators. The light typically must be collected by gradient index fiber lenses (with a numerical aperture of 0.08 to 0.3). This results in low overall optical system efficiency, usually less than 5%. Moreover, for a typical 3300 spot or pixel system, the LEDs that comprise the array must be time multiplexed by a factor of 20 or so or else 3300 drive transistors must be used. These factors combine to produce a very low level of energy at the photoreceptor, with resultant limitation of the processing speed to the approximately 50 mm/second range.

Moreover, since III-V class LED materials, such as GaP and GaAs, when used as substrates, are easily damaged by saw cutting, etc., LED chips or arrays cannot normally be effectively butted together but instead must be staggered in two rows and then optically interlaced with rather complex and relatively expensive optical means such as a pair of gradient index fiber lenses. In addition, present state-of-the-art greatly limits the use of on-chip circuitry on III-V materials.

GB-A-1 467 096 discloses a method of making an array of semiconductor light-emissive elements using layers of GaAlAs of opposite conductivity on a GaAs substrate, with the n-type layer being doped by ion implantation.

GB-A-2 099 221 discloses an array of LEDs on one chip, and RAM and driver circuits on a separate chip mounted on the same substrate as that which supports the LED chip.

The present invention accordingly relates to a method for fabricating a high-speed, high-resolution LED array as claimed in the respective appended claims, and to the LED arrays produced.

The present invention will now be described by way of example, with reference to the accompanying drawings, in which:

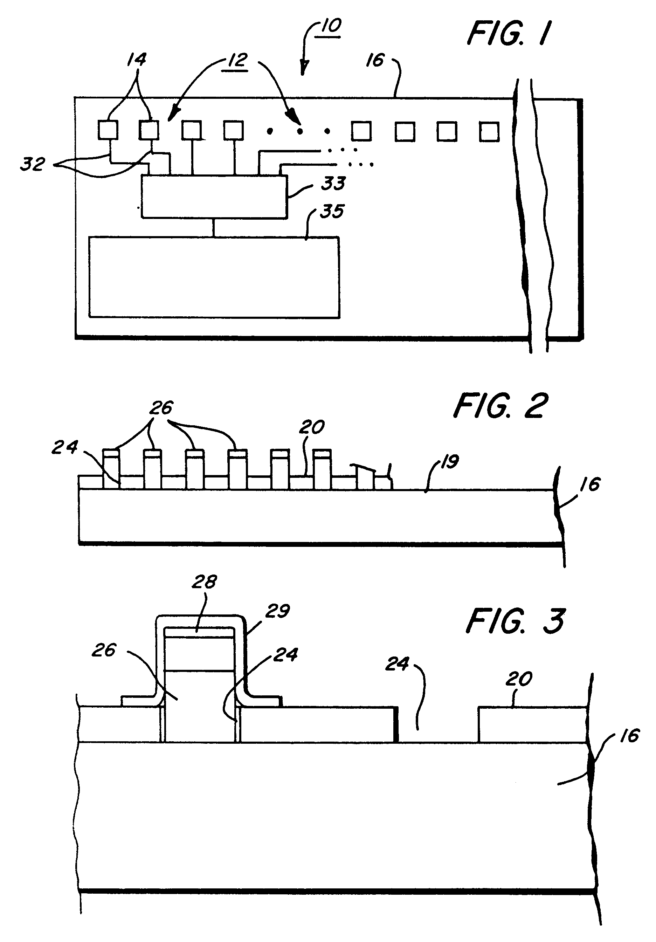

Figure 1 is a top view of a surface-emitting type LED chip;

Figure 2 is a side view in cross-section of the LED chip shown in Figure 1;

Figure 3 is an enlarged side view in cross-section showing details of a GaP LED chip fabricated on an SiO$_2$ coated substrate;

Figure 4 is a view illustrating a plurality of LED chips assembled together in staggered fashion to form a full-width write bar;

Figure 5 is a view illustrating a plurality of LED chips butted together end-to-end to form a full-width write bar;

Figure 6 is a side view in cross-section of a surface-emitting type IR LED according to the present invention;

Figure 7 is a top view showing the IR LED of Figure 6 in a multiple LED array;

Figure 8 is a side view in cross-section depicting an alternative surface-emitting type IR LED array construction according to the present invention;

Figure 9 is a top view of the IR LED shown in Figure 8 in a multiple LED array;

Figure 10 is an isometric view of an edge-emitting type IR LED according to the present invention;

Figure 11 is a top view showing the IR LED of Figure 10 in a multiple LED array;

Figure 12 is a side view in cross-section of the IR LED array shown with barriers to prevent optical cross-talk between adjoining LEDs; and

Figure 13 is a side view in cross-section illustrating a cross-talk preventing barrier formed by proton bombardment.

Referring to the drawings, there is shown the solid state full-width write bar, designated generally by the numeral 10. Write bar 10 has at least one linear array 12 of light-emitting diodes (LEDs) 14. In the exemplary arrangement described herein, write bar 10 is used to write, either directly or through suitable lens means, images on a moving record member such as a previously-charged photoreceptor (not shown) of a xerographic system,through selective actuation of the individual LEDs 14 in the array 12 in accordance with an image signal or pixel input. For this purpose, the array 12 of LEDs 14 has an overall length equal to or slightly greater than the effective width of the photoreceptor. Ordinarily, write bar 10 is disposed at right angles to the direction of photoreceptor movement and in predetermined spaced relation to the surface of the photoreceptor, as will be understood by those skilled in the art. As a result, write bar 10 writes, i.e. exposes, the photoreceptor a line at a time as the photoreceptor moves therepast to create a latent electrostatic image represented by the image signal input to write bar 10.

Following writing of the image on the photoreceptor by write bar 10, the latent electrostatic image created on the photoreceptor by LED write bar 10 is developed and transferred to a suitable copy substrate material such as a copy sheet. The copy sheet bearing the transferred image is thereafter fused or fixed to render the copy permanent while the photoreceptor is cleaned in preparation for recharging.

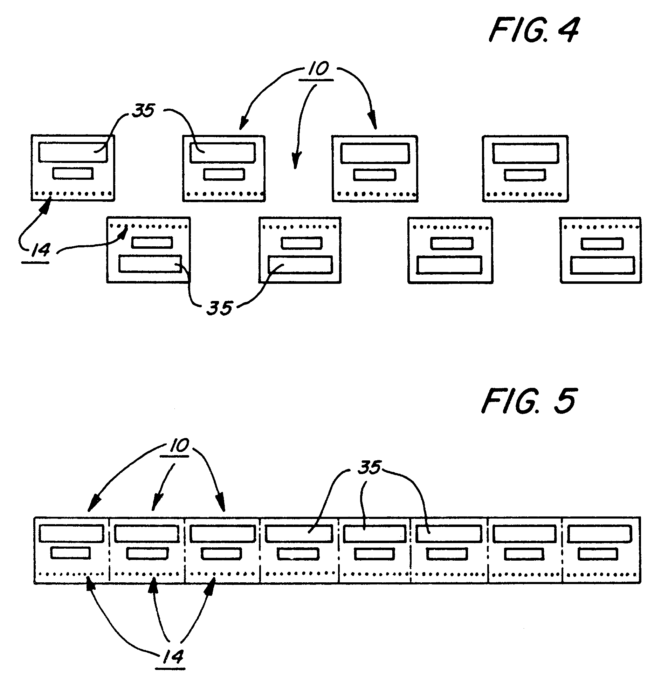

Write bar 10 is formed from a plurality of generally rectangular substrates or chips 16 separated as by sawing or other suitable means from one or more larger silicon wafers (not shown) for example. Chips 16 may be assembled in the staggered relationship as shown in Figure 4, or butted end-to-end as shown in Figure 5, to form a write bar of desired length. Where chips 16 are disposed in staggered fashion, as shown in Figure 4, the chips may, for example, be operatively joined or stitched together by suitable electrical circuitry effective to crossover from one chip to the next when writing an image line without loss or distortion of the image at the chip junctions. Alternatively, chips 16 may be optically joined or stitched together in effect to remove the stagger and align the images produced by each chip at the record member without loss or distortion of the image at the junctions between chips. Where a plurality of chips 16 is arranged in end-to-end relation, as shown in Figure 5, the chips, following alignment with one another, are joined together by suitable means to provide a write bar 10 of desired length.

The top or upper surface 19 of chip 16 is coated with a thin film layer 20 of silicon dioxide (SiO$_2$) for example. An array of holes 24 is next opened in layer 20, holes 24 being of a predetermined size, spacing, and orientation to provide an array 12 of desired size and resolution. Holes 24 may be formed photolithographically by placing a photo-mask of appropriate configuration (not shown) over layer 20 and applying a suitable etch to remove the layer 20 at the point where holes 24 are desired.

Following formation of holes 24, gallium phosphide (GaP) LED structures 26 are grown in each of the holes 24, preferably by chemical vapor deposition (CVD). Concurrently, p-n junctions 28 and electrical contact layers 29 are grown with each layer of the GaP LED structure 26. Other growing techniques may be employed instead, such as molecular beam epitaxy (MBE), liquid phase epitaxy (LPE), or metallo-organic chemical vapor deposition.

Following the formation of the GaP LED structures 26, LED contacts 32 and other supporting circuitry, such as a suitable fanout or distributing circuit 33 and a signal processing circuitry 35, are fabricated on chip 16 using conventional silicon integrated circuit (IC) techniques. Fanout circuit 33 provides image signals to the chips of write bar 10, either in parallel to the chips or serially to all chips of bar 10 in a preset sequence, or in a suitable serial/parallel combination. Since the GaP LED structures 26 are relatively high temperature materials, the IC processing, which is normally at a lower temperature, has no adverse effect on the previously-formed LED structures. A $Si_3N_4$ temporary protective coating may be placed over the GaP structure to minimize adverse effects during IC processing.

While write bar 10 is shown and described as having a silicon substrate with GaP LED structures, other substrate materials, such as gallium phosphide (GaP) or gallium arsenide (GaAs) which can operate in the visible or near infra-red, may instead be used as described below.

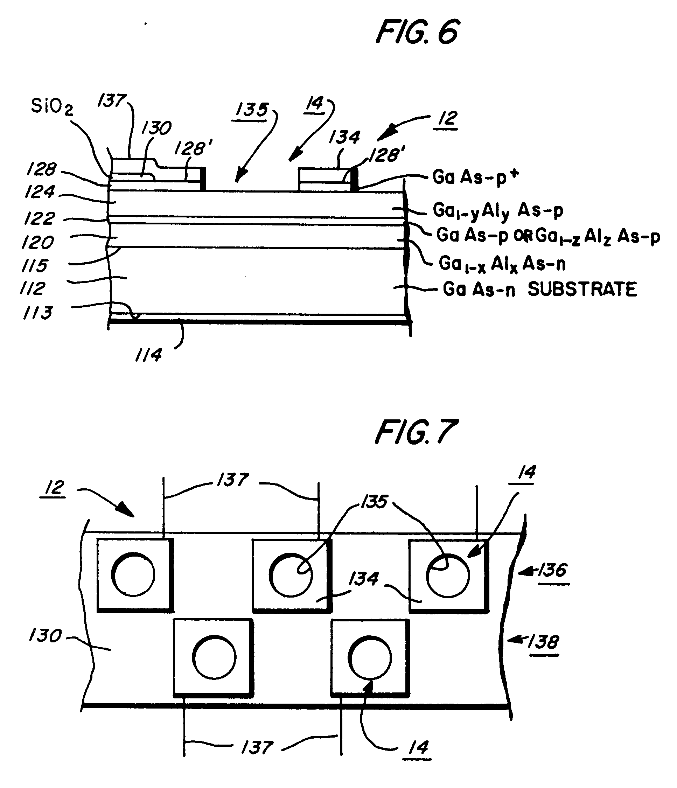

Referring now to Figures 6 and 7 of the drawings, a high efficiency heterostructure array 12 of IR LEDs 14 is fabricated according to the present invention. Heterostructure LED array 12 has a GaAs-n wafer or substrate 112, with one side 113 metallized to form a common electrical contact surface 114 for the LEDs of the array. A first layer 120 composed of $Ga_{1-x}Al_x$ As-n is grown on the opposite side 115 of substrate 112 followed by a layer 122 of either GaAs-p or $Ga_{1-z}Al_z$ As-p and a layer 124 of $Ga_{1-y}Al_y$ As-p. The thickness of substrate 112 is approximately 0.254 to 0.381 mm while the combined thickness of layers 120, 122, 124 is approximately 5 to 10 $\mu$m. Suitable ranges for x, y and z and approximate layer thicknesses for this embodiment are given in Table 1.

An electrical contact layer 128 of GaAs-p + (heavily doped p-type), which forms an electrical contact area for a metallization layer 134, is next grown over the layer 124, followed by an insulating layer 130 such as $SiO_2$. Contact and insulating layers 128, 130 are selectively etched at predetermined points to form an LED light-emitting area or window 135 of predetermined dimension and configuration defining each LED 14, LEDs 14 being formed a preset spaced intervals along wafer 112 in the array configuration desired. In the example shown in Figures 6 and 7, LEDs 14 are formed in parallel rows 136, 138, with the LEDs of each row being offset or staggered with respect to the LEDs of the other row. Further selective etching is used to remove the portion of insulating layer 130 bordering the LED windows 135 and uncover a portion 128' of contact layer 128. The uncovered portions 128' of bonding layer 128 surrounding each LED 14 are metallized at 134 to form a metal contact pad for each LED. A metal lead 137 is bonded to each LED contact pad.

While array 12 is shown and described as comprising two rows of LEDs 14, array 12 may comprise one or any number of parallel rows of LEDs 14.

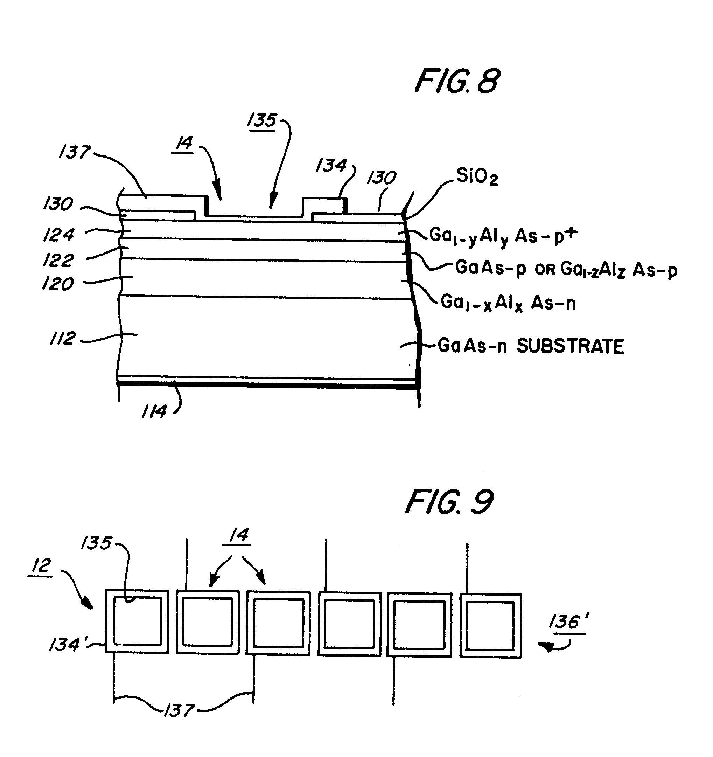

In the embodiment shown in Figures 8 and 9, where like numbers refer to like parts, the LEDs 14 of array 12 are there formed in a single row 136'. In this embodiment, contact layer 128 is dispensed with and the metallization layer 134 is placed directly on third layer 124, including the light-emitting windows 135 of LEDs 14. In this embodiment, metallization layer 134 is made extremely thin (or of a suitable transparent electrically conducting material) so that layer 134 is transparent to the light-emitting windows 135 of LEDs 14. Suitable ranges for x, y and z and approximate layer thicknesses for this embodiment are given in Table II.

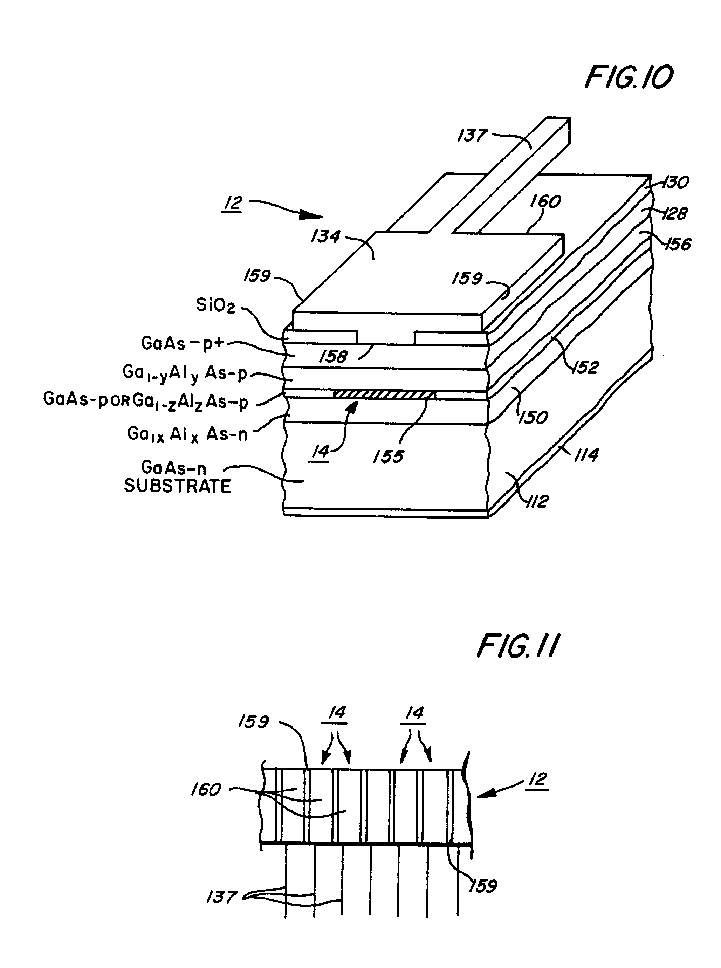

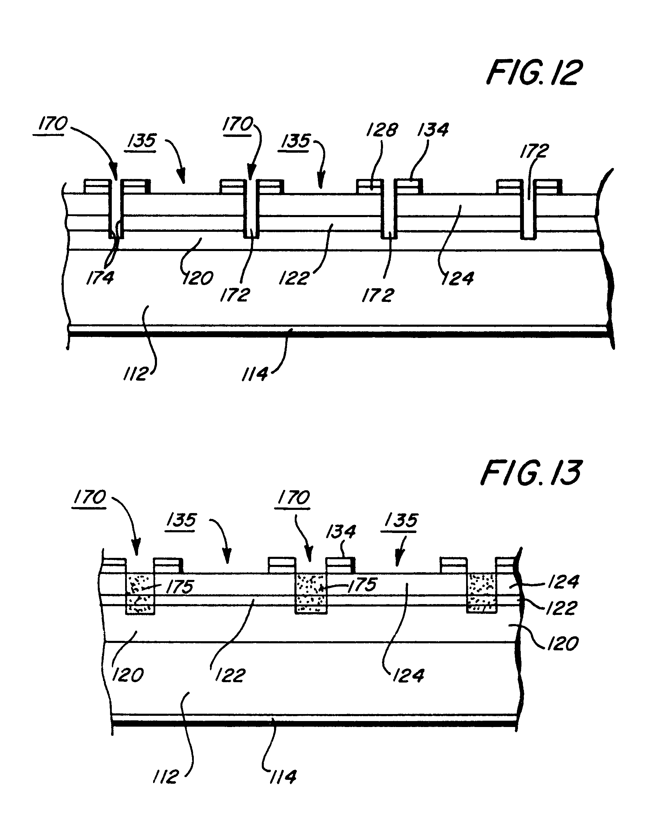

In the embodiment shown in Figures 6-9, array 12 comprises one or more linear arrays of surface-emitting LEDs. In the embodiment shown in Figures 10 and 11, where like numbers refer to like parts, array 12 comprises a linear array of edge-emitting LEDs. Referring thereto, a first layer 150 of $Ga_{1-x}Al_x$ As-n is grown on substrate 112 followed by an emitting layer 152 of GaAs-p or $Ga_{1-z}Al_z$ As-p. In this arrangement, LEDs 14 emit from layer 152 along edge 155 of substrate 112. Layer 156 of $Ga_{1-y}Al_y$ As-p is grown on layer 152 followed by contact layer 128 and insulating layer 130. Suitable ranges for x, y and z and approximate layer thicknesses for this embodiment are given in Table III.

In all of the above structures, a layer of GaAs-n of 1 to 5 $\mu$m thick may be grown prior to the first $Ga_{1-x}Al_x$As layer to act as a buffer layer and improve crystal quality. If this buffer layer is used, first layer 120 (Figures 6-9) or 150 (Figures 10, 11) can be as thin as approximately 0.5 to 1.0 $\mu$m.

Insulating layer 130 is selectively etched to uncover a generally rectangular area 158 of contact layer 128 above each LED 14. A strip-like portion 159 of metallization layer 134 is removed along each side to provide electrical isolation between adjoining LEDs of the array. Metallization layer 134 covers the areas 158 of contact layer 128 to form contact pads 160 for the LEDs 14. Leads 137 are bonded to contact pads 160.

Referring now to the embodiments shown in Figures 12 and 13, where like numbers refer to like parts, to avoid crosstalk between adjoining LEDs 14 of array 12 because of internal material transparency, which permits an "on" LED to cross-couple light into an adjacent "off" LED, a light barrier 170 is provided between adjoining LEDs 14. In the arrangment shown in Figure 12, barrier 170 is produced by etching, either chemically or through an ion etch, a channel 172 through metal contact layer 134, contact layer 128,

$Ga_{1-y}Al_y$ As-p layer 124, GaAs-p layer 122 and either into or through the $Ga_{1-x}As_x$ As-n layer 120. The interior walls of channel 172 are coated with a suitable light reflective or absorbing layer 174. Where a reflective light barrier is desired, layer 174 may comprise any suitable light-reflecting material such as a reflective metal with a suitable insulator layer thereunder to prevent short-circuiting of the LED. Where a light absorbing layer is desired, layer 174 may comprise any suitable non-conducting light-absorbing material such as dyed polyimide or developed, dyed photoresist.

In the embodiment shown in Figure 13, light barrier 170 is formed by controlled proton bombardment using a mask to expose the region between adjoining LEDs 14, the latter producing a barrier region 175 of high optical absorption and high electrical resistivity. Additionally, the embodiments shown in Figures 12 and 13 will reduce lateral current spreading under the electrical contact 128' and in layers 128, 124, and 122 and improve the efficiency of the LEDs.

While light barrier 170 is illustrated as comprising a channel-like recess having a generally rectangular shape when viewed in the cross section, other configurations, such as a V-shape, may be used.

Similiar heterostructure LED arrays may also be formed using indium gallium arsenide phosphide (InGaAsP) material. These LEDs also can operate with high efficiency and can be made for the wavelength range of approximately 1.1 to 1.7 $\mu$m.

As has been described in US-A-4,424,524 LED arrays of the type described herein can also be used as photodiode arrays for image recording. Since GaAs/GaAlAs and InGaAsP are direct band gap materials, they should provide high optical absorption and efficient photodiode array systems.

TABLE I

| Approximate compositions and thicknesses of various layers shown in Figures 6 and 7: | | |
|---|---|---|
| Layer | Approx. Composition (atomic fraction) | Approx. Thickness ($\mu$m) |
| 20 | x = 0.2 to 0.5 | 2 to 10 |
| 22 | z = 0.0 (GaAs) | 0.3 to 1.0 |
| 24 | y = 0.2 to 0.5 | 1 to 2 |
| 28 | 0.0 | 0.2 to 1.0 |
| 20 | x = z + (0.2 to 0.5) | 2 to 10 |
| 22 | z = 0.0 to 0.30 | 0.3 to 1.0 |
| 24 | y = z + (0.2 to 0.5) | 1 to 2 |
| 28 | 0.0 | 0.2 to 1.0 |

TABLE II

| Approximate compositions and thicknesses of various layers shown in Figures 8 and 9: | | |
|---|---|---|
| Layer | Approx. Composition (atomic fraction) | Approx. Thickness ($\mu$m) |
| 20 | x = 0.3 to 0.6 | 2 to 10 |
| 22 | z = 0.0 (GaAs) | 0.3 to 1.0 |
| 24 | y = 0.1 to 0.35 | 1 to 2 |
| 20 | x = z + (0.3 to 0.6) | 2 to 10 |
| 22 | z = 0.0 to 0.2 | 0.3 to 1.0 |
| 24 | y = z + (0.1 to 0.15) | 1 to 2 |

TABLE III

| Approximate compositions and thicknesses of various layers shown in Figures 10 and 11: | | |
|---|---|---|
| Layer | Approx. Composition (atomic fraction) | Approx. Thickness ($\mu$m) |
| 50 | $x = z + (0.3 \text{ to } 0.5)$ | 2 to 10 |
| 52 | $z = 0.0 \text{ to } 0.30$ | 0.3 to 1 |
| 56 | $y = z + (0.3 \text{ to } 0.5)$ | 0.5 to 1.0 |
| 28 | 0.0 | 0.2 to 0.5 |

**Claims**

1. A method of forming a light-emitting diode (LED) array for assembly with at least one other like LED array to form a solid-state full-width array (10) of LEDs, including the steps of:

a) metallizing a first major surface of a GaAs-n substrate (112) to provide a common electrical contact (114) for the LEDs;

b) growing a first layer (120), of GaAlAs-n, on the second major surface of the substrate;

c) growing a second layer (122), of GaAs-p or GaAlAs-p on the first layer;

d) growing a third layer (124), of GaAlAs-p, on the second layer to form a double hetero-structure together with the first and second layer

e) depositing a layer (130) of insulation material on the third layer;

f) etching away the insulation layer at selected areas to expose chosen areas of the third layer to form windows (135) defining each of the LEDs, and

g) metallizing the areas of the third layer exposed by the windows to provide individual electrical contacts (134) for each of the LEDs.

2. The method according to claim 1, including the steps of:

a) growing an electrical contact layer (128) of GaAs-p$^{+}$ on the third layer (124) before the insulation layer (130) is deposited on the electrical contact layer;

b) etching away both the insulation and contact layers to expose the chosen areas of the third layer to form the windows (135);

c) etching a portion of the insulation layer in the area bordering each of the windows to expose a portion (128') of the contact layer, and

d) metallizing the exposed portions of the contact layer to provide individual electrical contacts (134) for each of the LEDs.

3. The method according to claim 1, including the step of metallizing both the third layer areas comprising the windows, and the windows themselves, with a transparent electrically-conducting covering to provide electrical contacts for each of the LEDs.

4. The method according to any preceding claim, including the step of forming a light barrier (172) between adjacent LEDs to prevent optical crosstalk therebetween, by etching a recess (172) through the insulation, contact, third, and second layers and into or through the first layer.

5. An array of infra-red light-emitting diodes (LEDs) for assembly with a least one other like LED array to form a solid-state full-width array of LEDs for printing images, including:

a) a GaAs-n substrate (112), the first major surface of the substrate being metallized to provide a common electrical contact (114) for the LEDs;

b) a first layer (120), of GaAlAs-n, on the second major surface (115) of the substrate;

c) a second layer (122), of GaAs-p or GaAlAs-p, on the first layer;

d) a third layer (124), of GaAlAs-p, on the second layer forming a double hetero-structure together with the first and second layer;

e) a layer (130) of insulation material on the third layer, the insulation layer being provided with windows (135) exposing chosen areas of the third layer defining each of the LEDs, and

f) a metal contact layer on the surfaces of the third layer exposed by the windows, to provide individual electrical contacts for the LEDs.

6

**6.** The array according to claim 5, including

a) a fourth layer (128) of GaAs-p +, between the third layer and the insulation layer;

b) the windows extending through both the insulation and the fourth layers;

c) the insulation layer bordering each of the windows being absent to expose areas (128') of the fourth layer, and

d) a metal contact layer (134) on the exposed areas of the fourth layer to provide individual electrical contacts for each of the LEDs.

**7.** The array according to claim 8 or 9, including a recess (172) between adjoining LEDs forming a light barrier to prevent optical crosstalk between the adjoining LEDs.

**Revendications**

**1.** Procédé pour former un module de diodes électroluminescentes (DEL) pour assemblage avec au moins un autre module de diodes électroluminescentes identique pour former un module pleine largeur à l'état solide (10) de diodes électroluminescentes, comportant les étapes consistant à :

a) métalliser une première surface principale d'un substrat de GaAs-n (112) pour procurer un contact électrique commun (114) pour les diodes électroluminescentes ;

b) mettre à croître une première couche (120) de GaAlAs-n sur la seconde surface principale du substrat ;

c) mettre à croître une seconde couche (122) de GaAs-p ou de GaAlAs-p sur la première couche ;

d) mettre à croître un troisième couche (124) de GaAlAs-p sur la seconde couche pour former une double hétérostructure en même temps que la première et la seconde couches ;

e) déposer une couche (130) d'un matériau isolant sur la troisième couche ;

f) graver et éliminer la couche isolante à des zones sélectionnées pour exposer les zones choisies de la troisième couche afin de former des fenêtres (135) définissant chacune des diodes électroluminescentes, et

g) métalliser les zones de la troisième couche exposées par les fenêtres pour procurer des contacts électriques individuels (134) pour chacune des diodes électroluminescentes.

**2.** Procédé selon la revendication 1, comportant les étapes consistant à :

a) mettre à croître une couche de contact électrique (128) de GaAs-p + sur la troisième couche (124) avant que la couche isolante (130) soit déposée sur la couche de contact électrique ;

b) graver et éliminer à la fois les couches isolante et de contact pour exposer les zones choisies de la troisième couche pour former les fenêtres (135) ;

c) graver une partie de la couche isolante dans chaque zone bordant chacune des fenêtres pour exposer une partie (128') de la couche de contact, et

d) métalliser les parties exposées de la couche de contact pour procurer des contacts électriques individuels (134) pour chacune des diodes électroluminescentes.

**3.** Procédé selon la revendication 1, comportant l'étape consistant à métalliser à la fois les zones de la troisième couche comprenant les fenêtres et les fenêtres elles-mêmes, avec un revêtement transparent électriquement conducteur pour procurer des contacts électriques pour chacune des diodes électroluminescentes.

**4.** Procédé selon l'une quelconque des revendications précédentes, comportant l'étape consistant à former une barrière contre la lumière (172) entre des diodes électroluminescentes contigues pour empêcher la diaphonie optique entre celles-ci en gravant un évidement (172) à travers les troisième et seconde couches isolante et de contact et dans ou à travers la première couche.

**5.** Module de diodes électroluminescentes dans l'infrarouge (LED) pour assemblage avec au moins un autre module de diodes électroluminescentes identique pour former un module pleine largeur à l'état solide de diodes électroluminescentes pour l'impression d'images, comportant :

a) un substrat de GaAs-n (112) sur la première surface principale du substrat étant métallisée pour procurer un contact électrique commun (114) pour les diodes électroluminescentes ;

b) une première couche (120) de GaAlAs-n sur la seconde surface principale (115) du substrat ;

c) une seconde couche (122) de GaAs-p ou de GaAlAs-p sur la première couche ;

d) une troisième couche (124) de GaAlAs-p sur la seconde couche formant une double hétérostructure en même temps que les première et seconde couches ;

e) une couche (130) d'un matériau isolant sur la troisième couche, la couche isolante étant prévue avec des fenêtres (135) exposant des zones choisies de la troisième couche définissant chacune des diodes électroluminescentes, et

f) une couche de contact métallique sur les surfaces de la troisième couche exposée par les fenêtres, pour procurer des contacts électriques individuels pour les diodes électroluminescentes.

6. Module selon la revendication 5, comportant :

a) une quatrième couche (128) de GaAs-p+ entre la troisième couche et la couche isolante ;

b) les fenêtres s'étendant à travers à la fois la couche isolante et la quatrième couche ;

c) la couche isolante bordant chacune des fenêtres étant absente pour exposer les zones (128') de la quatrième couche, et

d) une couche de contact métallique (134) sur les zones exposées de la quatrième couche pour procurer les contacts électriques individuels pour chacune des diodes électroluminescentes.

7. Module selon la revendication 8 ou 9, comportant un évidement (172) entre des diodes électroluminescentes attenantes formant une barrière contre la lumière pour empêcher la diaphonie optique entre les diodes électroluminescentes attenantes.

**Patentansprüche**

1. Verfahren zum Bilden einer Anordnung Licht-emittierender Dioden (LED) zur Anordnung mit wenigstens einer weiteren, ähnlichen LED-Anordnung zum Bilden einer Festkörper-Anordnung voller Breite (10) aus LEDs, das folgende Verfahrensschritte umfaßt:

a) Metallisieren einer ersten Hauptoberfläche eines GaAs-n-Substrats (112), um einen gemeinsamen elektrischen Kontakt (114) für die LEDs zu erzeugen;

b) Aufwachsen einer ersten Schicht (120) aus GaAlAs-n auf der zweiten Hauptoberfläche des Substrats;

c) Aufwachsen einer zweiten Schicht (122) aus GaAs-p oder GaAlAs-p auf der ersten Schicht;

d) Aufwachsen einer dritten Schicht (124) aus GaAlAs-p auf der zweiten Schicht, um zusammen mit der ersten und zweiten Schicht eine Doppelheterostruktur zu erzeugen;

e) Abscheiden einer Schicht (130) aus isolierendem Material auf der dritten Schicht;

f) Wegätzen der isolierenden Schicht an ausgewählten Bereichen, um ausgewählte Bereiche der dritten Schicht freizulegen, um Fenster (135) zu bilden, die jede der LEDs definieren, und

g) Metallisieren der Bereiche der dritten Schicht, die durch die Fenster freigelegt werden, um einzelne elektrische Kontakte (134) für jede der LEDs zu erzeugen.

2. Verfahren nach Anspruch 1 mit folgenden Verfahrensschritten:

a) Aufwachsen einer elektrischen Kontaktschicht (128) aus GaAs-p$^+$ auf der dritten Schicht, bevor die Isolierschicht (130) auf die elektrische Kontaktschioht abgeschieden wird;

b) Wegätzen sowohl der Isolier- als auch der Kontaktschichten, um die ausgewählten Bereiche der dritten Schicht zum Bilden der Fenster (135) freizulegen;

c) Ätzen eines Teils der Isolierschicht in dem an jedes Fenster angrenzenden Bereich, um einen Teil (128') der Kontaktschicht freizulegen, und

d) Metallisieren der freigelegten Teile der Kontaktschicht, um einzelne elektrische Kontakte (134) für jede der LEDs zu erzeugen.

3. Verfahren nach Anspruch 1 mit dem Schritt zum Metallisieren sowohl der Bereiche der dritten Schicht einschließlich der Fenster als auch der Fenster selbst mit einer transparenten, elektrisch leitfähigen Schicht, um elektrische Kontakte für jede der LEDs zu erzeugen.

4. Verfahren nach einem der vorhergehenden Ansprüche mit dem Schritt des Bildens einer Lichtbarriere (172) zwischen benachbarten LEDs, um ein optischen Übersprechen dazwischen zu verhindern, durch Ätzen einer Vertiefung (172) durch die isolierenden, Kontakt-, dritten und zweiten Schichten und in oder durch die erste Schicht.

5. Anordnung von Infrarotlicht-emittierenden Dioden (LEDs) zur Anordnung mit wenigstens einer weiteren, ähnlichen LED-Anordnung zum Bilden einer Festkörper-Anordnung voller Breite aus LEDs zum Druk-

ken von Bildern mit:

a) einem GaAs-n-Substrats (112), wobei die erste Hauptoberfläche des Substrats metallisiert ist, um einen gemeinsamen elektrischen Kontakt (114) für die LEDs zu erzeugen;

b) einer ersten Schicht (120) aus GaAlAs-n auf der zweiten Hauptoberfläche (115) des Substrats;

c) einer zweiten Schicht (122) aus GaAs-p oder GaAlAs-p auf der ersten Schicht;

d) einer dritten Schicht (124) aus GaAlAs-p auf der zweiten Schicht, die zusammen mit der ersten und zweiten Schicht eine Doppelheterostruktur erzeugt;

e) einer Schicht (130) aus isolierendem Material auf der dritten Schicht, wobei die isolierende Schicht mit Fenstern (135) versehen ist, die ausgewählte Bereiche der dritten Schicht, die jede der LEDs definieren, freilegen, und

f) einer Metallkontaktschicht auf Flächen der dritten Schicht, die durch die Fenster freigelegt werden, um einzelne elektrische Kontakte für jede der LEDs zu erzeugen.

6. Anordnung nach Anspruch 5 mit:

a) einer vierten Schicht (128) aus GaAs-p$^+$ auf der dritten Schicht und der Isolierschicht;

b) wobei sich die Fenster sowohl durch die isolierende als auch die vierte Schicht erstrecken;

c) wobei die an jedes der Fenster angrenzende Isolierschicht fehlt, um Bereiche der vierten Schioht freizulegen, und

d) einer Metallkontaktschicht (134) auf den freigelegten Bereichen der vierten Schicht, um einzelne elektrische Kontakte für jede der LEDs zu erzeugen.

7. Anordnung nach Anspruch 8 oder 9, mit einer Vertiefung (172) zwischen benachbarten LEDs, die eine, Lichtbarriere bildet, um ein optisches Übersprechen zwischen benachbarten LEDs zu verhindern.

FIG. 1

FIG. 2

FIG. 3

FIG. 4

FIG. 5

## FIG. 6

SiO₂

137 130 128' 135 14 134 128' 12

128 — Ga As-p⁺
124 — Ga₁₋ᵧAlᵧ As-p
122 — Ga As-p OR Ga₁₋ᵤAlᵤ As-p
120 — Ga₁₋ₓ Alₓ As-n
115 — Ga As-n SUBSTRATE
112
113

114

## FIG. 7

12 137 135 14

134 136

130 138

137 14

## FIG. 8

137  14  135  134  130  SiO$_2$

130
124 — Ga$_{1-y}$Al$_y$As-p$^+$
122 — GaAs-p OR Ga$_{1-z}$Al$_z$As-p
120 — Ga$_{1-x}$Al$_x$As-n

112 — GaAs-n SUBSTRATE

114

## FIG. 9

135  14
12
134'
136'
137

FIG.10

12

134

137

130

128

156

160

159

159

152

SiO$_2$

150

GaAs−p+

158

114

Ga$_{1-y}$Al$_y$ As−p

GaAs−p OR Ga$_{1-z}$Al$_z$ As−p

Ga$_{1x}$ Al$_x$ As−n

14

155

GaAs−n
SUBSTRATE

112

FIG.11

159

14

14

160

12

137

159

*FIG.12*

*FIG.13*